# EUROPÄISCHE PATENTSCHRIFT

(11) **EP 1 166 366 B1**
(45) Veröffentlichungstag und Bekanntmachung des Hinweises auf die Patenterteilung: **30.11.2011**
(21) Anmeldenummer: 00918752.7
(22) Anmeldetag: 29.02.2000
(51) Int. Cl.: H01L 31/068, H01L 31/0288, H01L 21/033, H01L 21/312, H01L 21/316

(54) **DOTIERPASTEN ZUR ERZEUGUNG VON P, P+ UND N, N+ BEREICHEN IN HALBLEITERN**
DOPING PASTES FOR PRODUCING P, P+ AND N, N+ ZONES IN SEMICONDUCTORS
PATES DE DOPAGE POUR LA PRODUCTION DE ZONES P, P+ ET N, N+ DANS DES SEMICONDUCTEURS

(30) Priorität: 11.03.1999 DE 19910816
(43) Veröffentlichungstag der Anmeldung: 02.01.2002
(60) Teilanmeldung: 10182228.6
(73) Patentinhaber: BASF SE, 67056 Ludwigshafen (DE)
(72) Erfinder: KÜBELBECK, Armin, D-64625 Bensheim (DE); ZIELINSKI, Claudia, D-64291 Darmstadt (DE); HEIDER, Lilia, D-64347 Riedstadt (DE); STOCKUM, Werner, D-64354 Reinheim (DE)
(86) Internationale Anmeldenummer: PCT/EP2000/001694
(87) Internationale Veröffentlichungsnummer: WO 2000/054341

(56) Entgegenhaltungen:
- EP-A- 0 834 489
- WO-A-93/24960
- WO-A-96/19012
- WO-A1-83/02200
- DE-A- 19 508 712
- US-A- 4 104 091
- US-A- 4 152 824
- US-A- 4 891 331
- US-A- 5 057 336
- US-A- 5 358 597
- US-A- 5 458 912
- PATENT ABSTRACTS OF JAPAN vol. 014, no. 241 (E-0931), 22. Mai 1990 (1990-05-22) & JP 02 066916 A (NEC CORP), 7. März 1990 (1990-03-07)
- PATENT ABSTRACTS OF JAPAN vol. 011, no. 141 (C-421), 8. Mai 1987 (1987-05-08) & JP 61 279665 A (SUMITOMO METAL MINING), 10. Dezember 1986 (1986-12-10)
- TAKESHI HATTORI: "CONTAMINATION CONTROL: PROBLEMS AND PROSPECTS", SOLID STATE TECHNOLOGY, PENNWELL CORPORATION, TULSA, OK, US, vol. 33, no. 7, 1 July 1990 (1990-07-01), pages 51-58, XP000136379, ISSN: 0038-111X

## Beschreibung

Die Erfindung betrifft neue Bor-, Phosphor- oder Bor-Aluminium- Dotierpasten zur Erzeugung von p, p+ und n, n+ Bereichen in monokristallinen und polykristallinen Si-Wafern in der Halbleiterherstellung, Leistungselektronik oder in photovoltaischen Anwendungen.

Bor- oder Phosphor-Dotierungen von monokristallinen Si-Wafern in der Photovoltaik und bei Leistungshalbleitern (z. B. Dioden, Thyristoren) erfolgen über die Gasphase (z. B. POCl₃, Phosphin, BBr₃) oder mit Feststoffen (Folien oder Feststoffscheiben) oder mit flüssigen Medien wie z. B. Phosphorsäure, und anderen B- bzw. P-organischen Systemen.

Ein unmittelbares strukturiertes Aufbringen ist mit diesen Technologien nicht möglich. Definierte Bereiche können nicht selektiv dotiert werden, ohne aufwendige z. B. photolithographische Prozesse zur Maskierung der Bereiche die nicht dotiert werden sollen, anzuwenden.

In der Photovoltaik kann durch die p++ Dotierung auf der Rückseite ein ganzflächiges oder lokales Back Surface Field (Local BSF) erzielt werden. Bestehende Produktionslinien arbeiten derzeit nur mit einem ganz- flächigen Back Surface Field, welches entweder durch eine Al- Metallschicht oder eine flüssige Borquelle erhalten wird. Lokale BSF sind zur Zeit nur im Labormaßstab verwirklicht worden, aus Gründen die im folgenden noch erläutert werden.

Ein ganzflächiges Back Surface Field ist unter anderem bei dünnen Si- Wafern (≤ 250 µm) besonders vorteilhaft, da sonst der Wirkungsgrad der Zelle deutlich niedriger ausfällt. Ein solches BSF wird zur Zeit bei Si- Wafern von > 300 µm Dicke durch ganzflächiges Bedrucken mit einer Aluminium-Paste erhalten [P. Lölgen ; F. J. Bisschop ; W. C. Sinke ; R. A. Steeman ; L. A. Verhoef et al. 6th PV Science and Engineering Conference, New Delhi, 1992, pp. 239]. Vorteilhaft ist dabei, daß zum einen mit dem Aluminium eine p+ Dotierung, d. h. also ein BSF aufgebaut wird und zum anderen mit dem Aluminium auch der an der Zelle erzeugte Strom abgeführt wird. Bei dünnen Wafern tritt allerdings nach dem Einbrennen der Aluminiumpaste eine Wölbung des Wafers auf. Somit erfordert die weitere Handhabung und Bearbeitung solcher Wafer besondere Maßnahmen, da der Einbau solcher gebogenen Zellen in die üblicherweise plan ausgeführten PV-Module sich ausgesprochen schwierig gestaltet.

In DE 195 08712 C2 und in K. A. Münzer, R. R. King, R. E. Schlosser, H. J. Schmidt, J. Schmalzbauer, S. Sterk, H. L. Mayer, 13th European Photovoltaic Solar Energy Conference, 23-27 10.1995, p. 1398 wird durch ein Spin-on Verfahren mit Bor versucht, dieses Problem zu lösen. Hier- bei wird eine p++ Dotierung durch Bor erzeugt und ein nachfolgender Druck eines Aluminiumrasters mittels Aluminiumpaste durchgeführt.

### Nachteile dieses Verfahrens sind

a) der große Materialbedarf des Spin on-Verfahrens
b) der erhebliche apparative Aufwand, mit dem eckige Wafer nach dem Spin on-Verfahren gleichmäßig zu beschichten sind
c) der hohe Durchsatz und die aufwendige Handhabung, welche in einer Massenfertigung nur unter großen Schwierigkeiten zu verwirklichen sind und
d) daß eine selektive Strukturierung der Wafer, wie weiter oben beschrieben nicht möglich ist.

Die US 4,104,091 offenbart eine Dotierpaste enthaltend ein aktives Material in Form von Metallen, Legierungen sowie Mischungen von pulverformigen Metallen oder Metallen, die chemisch an einen Träger gebunden sind wie beispielsweise Lösungen enthaltend Dotieratome, die an ein niedermolekulares Polymer gebunden sind, ein Glas mit niedrigem Schmelzpunkt und Lösungsmittel.

Die WO 83/02200 offenbart eine Dotierpaste enthaltend einen Dotierstoff, kolloidales Silica und Lösungsmittel.

Aufgabe der vorliegenden Erfindung war es daher, verbesserte, preiswerte in der Halbleitertechnik einsetzbare Dotierpasten zur Verfügung zu stellen, die die oben beschriebenen Nachteile nicht aufweisen und in einfacher Weise einsetzbar sind. Aufgabe der vorliegenden Erfindung war es auch, entsprechende siebdruckfähige Pasten zur Verfügung zu stellen.

Die Lösung der Aufgabe erfolgt durch Dotierpasten zum selektiven Strukturieren und zum ganzflächigen Bedrucken von Si-Wafern durch Sieb-, Rollen-, Tampon-, Schablonendruck oder andere in der Halbleitertechnologie übliche Drucktechnologien für die Herstellung von p, p+, p++, n, n+, n++-Bereichen im Si-Wafer, enthaltend
a) eine oder mehrere dotierend wirkende Komponenten,
b) ein oder mehrere Alkoxysilane, und
c) Lösungsmittel,
d) gegebenenfalls eine Säure und Wasser
   und gegebenenfalls
e) Additive, wie Verdickungsmittel oder Netzmittel,
   wobei die Gesamtzusammensetzung Verunreinigungen in Form von Metallionen in jeweiligen Konzentrationen von weniger als 500 ppb auf- weist, vorzugsweise von weniger als 200 ppb.

Durch Versuche wurde gefunden, daß durch die hiermit gefundenen siebdruckfähigen Dotierpasten die oben angeführten Nachteile entfallen.

Die erfindungsgemäßen Pasten können eine Dotierquelle, ausgewählt aus der Gruppe Borsalz, Boroxid, Borsäure, organischen Verbindungen des Bors, Bor-Aluminiumverbindungen und Phosphorsalz, Phosphoroxid, Phosphorpentoxid, Phosphorsäure, phosphororganische Verbindungen und organische Verbindungen des Aluminiums, sowie Aluminium-Salze enthalten.

Prinzipiell geeignet sind die dem Fachmann bekannten Verbindungen v. a. der III. und V. Hauptgruppe des Periodensystems der Elemente.

Weiterhin enthalten die entsprechenden Pasten eine SiO₂-Matrix, bestehend aus einem oder mehreren SiO₂-Precursoren.

Die gefundenen Dotierpasten können ein oder mehrere Dotierquellen ausgewählt aus der Gruppe Boroxid (B₂O₃), Phosphorsäure (H₃PO₄), Phosphorpentoxid (P₂O₅) und Aluminiumsalz enthalten, wobei die Dotierungsquellen in unterschiedlichen Konzentrationen eingesetzt werden können.

Gegenstand der vorliegenden Erfindung sind auch Dotierpasten, welche eine oder mehrere Dotierquellen aus der Gruppe der organischen Verbindungen des Bors, Phosphors und Aluminiums enthalten, wobei die

Dotierungsquellen in unterschiedlichen Konzentrationen eingesetzt werden können.

Weiterhin erfolgt die Lösung der Aufgabe durch Dotierpasten, enthaltend ein oder mehrere Dotierquellen ausgewählt aus der Gruppe Boroxid (B₂O₃), Phosphorsäure (H₃PO₄), Phosphorpentoxid (P₂O₅) und Aluminiumsalz oder Aluminium-organische Verbindungen und gegebenenfalls eine oder mehrere Dotierquellen aus der Gruppe der organischen Verbindungen des Bors, Phosphors und Aluminiums, wobei die Dotierungsquellen in unterschiedlichen Konzentrationen eingesetzt werden können.

Die in der Dotierpaste enthaltene SiO₂-Matrix kann erfindungsgemäß aus silziumorganische Verbindung der allgemeinen Formel
R'ₙSi (OR)₄₋ₙ,
worin
R' Methyl, Ethyl oder Phenyl,
R Methyl, Ethyl, n-Propyl, oder i-Propyl
und
n 0,1 oder 2
bedeuten,
gebildet werden.

Gegenstand der vorliegenden Erfindung ist weiterhin eine Dotierpaste, die eine SiO₂ Matrix enthält, welche aus Silanen, ausgewählt aus der Gruppe Tetramethoxysilan, Tetraethoxysilan, Tetrabutoxysilan einzeln oder im Gemisch gebildet wird.

Gegenstand der vorliegenden Erfindung ist auch die Verwendung der beschriebenen neuen Dotierpasten in der Halbleitertechnik, der Photovoltaik oder in der Leistungselektronik.

Man kann mittels siebdruckfähiger Pasten ebenfalls kostengünstig und mit hohem Durchsatz ganzflächig oder selektiv (selektiver Emitter) eine Phosphordotierung erzielen.

Strukturierungsschritte, die aktuell durch photolithographische Verfahren ermöglicht werden, können kostengünstig durch den Einsatz von siebdruckfähigen Dotierpaste ersetzt werden.

Die Lösung der Aufgabe erfolgt durch neue Pasten zur selektiven Herstellung von dotierten Silikatschichten mit Phosphor, Bor und Bor- Aluminium Diese Pasten sind geeignet für den Einsatz in drucktechnischen Verfahren in der Elektronikindustrie. Im speziellen zählen hierzu die Siebdrucktechnologie oder der Tampondruck.

Je nach gewünschtem Einsatzgebiet können in den verwendeten Pasten sowohl die Konzentrationen der Einzelkomponenten als auch die Viskositäten variiert werden.

Weiterhin zeichnen sich die erfindungsgemäßen Dotierpasten durch eine definierte Matrix aus. Diese wird durch eine SiO₂ bildende Komponente beim Aufheizen im Diffussionsprozeß gebildet. Zusammen mit der Bor- bzw. Phosphor-liefernden Komponente bildet sich ein in der Literatur [K. Spanowsky, Die Diffusion von Bor mit Hilfe von Spin-on-Gläsern in der MOS-Technologie, Diplomarbeit, 1996; R. Fischer, Experimente zur Klärung des Diffusionsmechanismus von Phosphor in Silizium, Diplomarbeit, 1994] beschriebenes und dem Fachmann bekanntes Boro- bzw. Phosphorsilikatglas (B₂0₃)ₓ * (SiO₂)_{y} bzw. (P₂O₅)ₓ * (SiO₂)_{y}. Dieses Glas bildet die eigentliche Quelle für den Dotierstoff bei der Dotierung.

Die Menge der SiO₂ bildenden Komponente in der Dotierpaste liegt in einem modifizierbaren Bereich von 0,1 - 5 Gew.-%. Bezogen auf die Dotierkomponenten B₂O₃ bzw. P₂O₅ kann das Verhältnis SiO₂ zu B₂O₃ bzw. P₂O₅ beliebig eingestellt werden, vorteilhaft ist jedoch der Bereich von 10-80% Dotiermittel in SiO₂. Über dieses Verhältnis kann die zu erreichende Dotierstoffkonzentration im Silizium gut gesteuert werden. Die Eindringtiefe des Dotierstoffes wird, wie in der Literatur bekannt [A. Goetzberger; B. Voß; J. Knobloch, Sonnenenergie: Photovoltaik, Teubner Studienbücher Stuttgart 1997, pp 40; 107], über die Parameter Diffussionszeit und -temperatur gesteuert.

Der Dotierprozess wird durch eine kontrollierte Diffusion in Luft oder Sauerstoff Atmosphäre durchgeführt. Die Temperaturen für die Phosphordiffusion liegen z.B. bei 900 - 950°C für Phosphor, für die Bordiffusion bei ca. 950 - 1250°C. Die Diffusionstemperatur richtet sich auch nach den verwendeten Si-Wafern. Bei monokristallinen Wafern kann die Diffusionstemperatur höher liegen, d. h. bis ca. 1250 °C, da diese temperaturstabiler sind als die multikristallinen Wafer.

Zusätzlich kann die Diffusion auch mit der Rapid Thermal Processing (RTP)-Technologie durchgeführt werden.

Die Diffusionsdauer kann je nach Anwendungszweck wenige Minuten bis zu 60 Stunden oder mehr betragen. Nach der Diffusion werden die Wafer mit HF (Konzentration ca. 2 - 50% HF) behandelt, um das gebildete Phosphor- oder Borsilikatglas (PSG, BSG) abzulösen. Nach dieser Behandlung liegt der Si-Wafer mit freier Si-Oberfläche vor. Die Dotierkomponente liegt im Konzentrationsbereich von bis zu 10 % bezogen auf die Dotierpaste vor. Bei einer nicht erfindungsgemäßen, dotierstofffreinen (0 Gew.-%) Zusammensetzung wird eine Maskierungspaste erzeugt. Dieses erfolgt unter den gleichen Prozeßbedinungen wie bei den Dotierpasten.

Das Lösungsmittel bildet den Hauptbestandteil der Paste. Der Anteil kann im Bereich von 50 - 80 Gew.-% der Gesamtmenge liegen.

Der Anteil der Verdickungsmittel, die zur gezielten Einstellung des Viskositätsbereiches und grundsätzlich zur Druckfähigkeit des Dotiermittels erforderlich sind, d.h. zur Bildung einer druckfähigen Paste, liegt im Bereich von ca. 1 - 20 Gew.-% bezogen auf die Gesamtmenge der Paste.

Weitere Additive mit für den gewünschten Zweck vorteilhaften Eigenschaften sind Entschäumer, Haftvermittler, Verdickungsmittel, Netzmittel, Verlaufsmittel oder Thixotropiermittel. Diese können die Druckfähigkeit der Paste positiv beeinflußen.

Zur Bildung der Silizium-Matrix sind allgemein Alkoxysilane geeignet, insbesondere Silane der allgemeinen Formel :

| | |
|---|---|
| 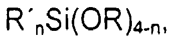 | |
| worin | |
| R' | Methyl, Ethyl oder Phenyl, |
| R | Methyl, Ethyl, n-Propyl, oder i-Propyl |
| und | |
| n | 0, 1 oder 2 |
| bedeuten . | |

Beispiele für geeignete Silane sind Tetramethoxysilan, Tetraethoxysilan, Tetrabutoxysilan, Tetrapropoxysilan, sowie höhere und gemischte Vertreter, d. h. Silane mit längeren Alkylketten bzw. Silane mit unterschiedlichen Alkylresten.

Weiterhin können vorteilhafterweise auch Mischungen verschiedener Alkyl- oder Alkoxysilane eingesetzt werden.

Gegebenenfalls müssen diese Verbindungen vorhydrolysiert werden. Vorteilhaft für die Herstellung der erfindungsgemäßen Pasten ist die Verwendung solcher Siloxane, die keiner Vorbehandlung bedürfen, wie z.B. Polysiloxane.

Beim Erhitzen der Substrate im Diffussionsofen bilden die siliziumorganischen Verbindungen Siliziumdioxid z.B. nach folgender Gleichung:

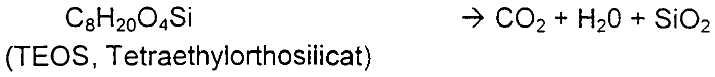

Zur Herstellung der Dotiermatrix können als anorganische Komponenten von Verbindungen des Bors und Phosphors, sowie Aluminiumverbindungen eingesetzt werden. Beispiele hierfür sind Boroxid B₂O₃, Borsäure B(OH)₃, Phoshorsäure H₃PO₄, P₂O₅ und Al-Salze oder Aluminium-organische Verbindungen.

Als organische Komponenten sind organische Verbindungen des Bors und Phosphors, sowie aluminiumorganische Verbindungen einsetzbar.

Weiterhin können den erfindungsgemäßen Pasten Additive hinzugefügt sein. Dieses können sowohl organische als auch anorganische Säuren sein, wie z.B. Salpetersäure, Salzsäure, Milchsäure, Oxalsäure, Ameisensäure oder andere. Insbesondere werden diese Säuren hinzugefügt, wenn eine Hydrolyse der Si-organischen Verbindung durchgeführt werden muß. Allgemein sind solche organischen Säuren einsetzbar, deren Alkylreste eine Kettenlänge von n = 1 - 10 aufweisen. Es können organische Säuren eingesetzt werden, die einen Rest R = OH oder = Alkyl mit n = 1 - 10 aufweisen. Die Alkylreste der einsetzbaren Säuren können sowohl geradkettig als auch verzweigt sein.

Entsprechende Additive in den erfindungsgemäßen Pasten sind notwendig, wenn die siliziumorganische Verbindung vorhydrolysiert werden muß. Bei Siloxan jedoch beispielsweise kann dieses Additiv entfallen. Als Verdickungsmittel sind Thixoton^{®} (Rizinusöl), BorchigenTS^{®} (rheologisches Additiv für Kieselsäuren), Bentonite unterschiedlicher Qualitäten und Eigenschaften, allgemein anorganische Rheologie-Additive für unterschiedlich polare Lösungsmittelgemische, Nitrocellulose, Ethylcellulose und andere Celluloseverbindungen, Polyvinylpyrollidone unterschiedlicher Qualität, Stärke (+NH₄OH), Gelatine, Alginsäure, hochdisperse amorphe Kieselsäure (Aerosil^{®}), Polyvinylbutyral (Mowital^{®}) (gut löslich z. B. in Butylglycol, Natriumcarboxylmethylstärke (vivastar), thermoplastisches Polyamidharz (Eurelon^{®}) (muß verkocht werden bei ca. 180°C), organisches Rizinusölderivat (Thixin R^{®}), Diamidwachs (Thixatrol plus^{®}), quellende Polyacrylate (Rheolate^{®}), Polyetherharnstoff-Polyurethan (Rheolate^{®}), Polyether-Polyole (Rheolate^{®}) geeignet.

Als Verlaufsmittel können Polysiloxane, Siloxane und Trisiloxane eingesetzt werden.

Besonders gut geeignete Additive sind solche, die eine gute Bindung mit den anderen Komponenten eingehen, vorteilhaft bei Temperaturen unterhalb von 200°C klebfrei vorgetrocknet werden können und bei 200 - 500°C rückstandsfrei verbrennen.

Die Viskosität der hochreinen Dotierpaste wird durch das Verdickungsmittel, wie auch durch das verwendete Lösungsmittel eingestellt.

Eine Grundvoraussetzung für eine gute Dotierpaste in der Photovoltaik ist eine möglichst geringe Verunreinigung mit metallischen Verbindungen. Insbesondere die Kationen der Metalle Eisen, Chrom, Kupfer, Nikkel, Gold, Calcium usw., vielfach in der Literatur als "Killer"-Trägerlebensdauer bezeichnet, sind unerwünscht. Ihre Konzentrationen liegen unterhalb von 500 ppb in der Paste. In einigen Fällen sollten die Konzentrationen möglichst 200 ppb nicht überschreiten. Um diese Bedingungen einhalten zu können, sind in einigen Fällen nur aufgereinigte Ausgangsmaterialien einsetzbar.

Außer den bisher genannten Komponenten ist zur Herstellung der Pasten die Zugabe von Lösungsmittel notwendig.

Geeignete organische Lösungsmittel sind hydrophile Polyalkohole, wie Ethylenglykol, Methylcellosolve, Methylcellosolveacetat, Ethylcellusolve, Diethylcellosolve, Cellosolveacetat, Ethylenglykolmonobutylether, Ethylenglykolmonophenylether, Methoxymethoxyethanol, Ethylengklykolmonoacetat, Ethylenglykoldiacetat, Diethylenglykol, Diethylenglykolmonomethylether, Diethylenglykolmonoethyletheracetat, Diethylenglykolmonobutylether, Diethylenglykolmonobutyletheracetat, Diethylenglykoldimethylether, Diethylenglykolmethylethylether, Diethylenglykoldiethylether, Diethylenglykolacetat, Triethylglykol, Triethylenglykolmonomethylether, Triethylenglykolmonoethylether, Tetraethylenglykol, FI. Polyethylenglykole, Propylenglykol, Propylenglykolmonomethylether, Propylenglykolmonoethylether, Propylenglykolmonbutylether, 1-Buthoxyethoxypropanol, Dipropylglykol, Dipropylenglykolmonomethylether, Dipropylenglykolmonoethylether, Tripropylenglykolmonomethylether, Polypropylenglykole, Trimethylenglykol, Butandial, 1,5-Pentandial, Hexylenglykol, Glycerin, Glycerylacetat, Glyceryldiacetat, Glyceryltriacetat, Trimethylolpropyn, 1,2,6,-Haxantriol oder deren hydrophile Derivate, sowie aliphatische und aromatische mehrwertige Alkohole, wie z. B. 1, 2-Propandiol, 1,5-Pentandiol, Oktandiol aber auch deren Ester und Ether oder Gemische dieser Lösungsmittel.

Ein geeignetes Lösungmittel kann beispielsweise als Hauptbestandteil 1,2-Butandiol enthalten. Als geeignet haben sich solche Lösungsmittelgemische erwiesen in denen 30 - 95 Gew% 1,5 Pentandiol enthalten sind. In einem solchen Gemisch können Ethylenglycolmonobutylether (EGB), Diethylenglycolmonobutylether (DGB), Dipropylenglycolmonomethylether (DPM), 1.4 Butandiol (1.4BD), und 1.3 Butandiol (1.3BD) als weitere Lösungsmittel enthalten sein.

Weiterhin können als Lösungsmittel hydophile Ether, wie Dioxan, Trioxan, Tetrahydrofuran, Tetrahydropyran eingesetzt werden. Geeignet sind auch Methylal, Diethylacetal, Methylethylketon, Methylisobutylketon, Diethylketon, Acetonylaceton, Diacetonalkohol oder hydrophile Ester, wie Ameisensäuremethyl-, Ameisensäureethyl-, Ameisensäurepropyl-, Essigsäuremethyl-, Essigsäureethyl-ester.

Versuche haben gezeigt, daß zur Erreichung eines Dotiereffekts eine Belegung eines üblicherweise eingesetzten Wafers, z. B. 4 Zoll Wafer, mit einer Menge von 50-100 mg Paste ausreicht. Die Belegung der zu behandelnden Wafer mit der erfindungsgemäßen Paste kann mit dem Fachmann bekannten Methoden erfolgen. Insbesondere eignet sich für diesen Zweck das Aufbringen im Siebdruckverfahren. Die Umwandlung der aufgebrachten Pasten in die erwünschten dotierten Schichten erfolgt in bekannter Weise durch Erhitzen auf Temperaturen 200 bis 600 °C, vorzugsweise auf etwa 500 °C. Die erforderliche Dauer des Erhitzens ist abhängig von der Dicke der aufgebrachten Schicht Paste.

Die erfindungsgemäße Paste eignet sich zur Herstellung von p-n-Übergängen, wie z. B. in der Halbleitertechnik, insbesondere aber auch zur Verwendung in der Herstellung von in der Solartechnik verwendeten Solarzellen.

Beispielsweise wurde gefunden, daß sich durch Verwendung von erfindungsgemäßen Borpasten zur Herstellung von dotierten Glasschichten der Wirkungsgrad von Solarzellen, der üblicherweise in der Produktion bei 14 % liegt, um ca. 1,5 bis 2% gesteigert wird.

Zum besseren Verständnis und zur Verdeutlichung werden im folgenden Beispiele gegeben, die im Rahmen des Schutzbereichs der vorliegenden Erfindung liegen, nicht jedoch geeignet sind, die Erfindung auf diese Beispiele zu beschränken.

### Beispiel 1:

TEOS (1,43 g) wird in einem Becherglas vorgelegt. Im Anschluß daran wird das Lösungsmittel N-Methyl-pyrrolidon NMP (83 g) hinzugegeben und mit Hilfe eines Rührers die Grundmischung hergestellt. Nun erfolgt die sukzessive Zugabe von Polyvinylpyrrolidon (11 g), von di-Bortrioxid-(4,6 g) und zum Abschluß Milchsäure (3 g). Während der Zugabe muß weiterhin intensiv gerührt werden. Nach Abschluß der Zugabe wird die Mischung für ca. weitere 30 min gerührt. Die Abfüllung in Behälter erfolgt nach einer kurzen Standzeit. Diese Standzeit ist erforderlich, damit sich die in der Mischung gebildeten Bläschen auflösen können.

Diese Mischung ergibt eine Paste, wodurch ein Bor-Glas auf dem Wafer gebildet wird, d. h. es wird gezielt eine Dotierung des monokristallinen und polykristallinen Si-Wafers in gewünschter Borkonzentration erhalten.

Die erhaltene Paste ist lagerstabil, leicht zu handhaben und druckfähig. Sie kann mit üblichen Lösungsmitteln aus der Siebdruckgewebe entfernt werden.

### 2. Beispiele für Pasten mit einem Lösungsmittel oder mit Lösungsmittelgemischen:

### I. P-Paste:

| | | |
|---|---|---|
| 30g | 1.4-Butandiol | |
| 5g | P₂O₃ | |
| 53g | 1.2-Propandiol | |
| 1,5g | Trasil® | (Siliziumquelle; Alkylsilikonharz mit Alkoxygruppen) |
| 0,2g | Foamex N® | (Polydimethylsiloxan; Entlüfter) |
| 0,2g | Aerex® | (hochmolekulares organisches Polymer mit Siliconspitze; Entschäumer) |
| 3g | Byk 410® | (modifizierter Harnstoff; Thixotropiermittel) |
| 0,05g | TEGO Glide 400® | (Polyether-modifizierte Polysiloxane; |

| | | |
|---|---|---|
| 4g | PVP | (Polyvinylpyrrolidon ; Verdicker) |

### II. Borpaste

| | | |
|---|---|---|
| 83 g | 1,2-propandiol | |
| 4,6 g | B2O3 | |
| 1,43 g | TEOS | |
| 3 g | Milchsäure | |
| 2,5 g | Byk 410® | Thixotropiermittel |
| 0,05g | TEGO Glide 400® | Verlaufsmittel |
| 0,2 g | Aerex® | Entschäumer |
| 0,2 g | Foamex N® | Entlüfter |
| 4 g | PVP | Verdicker |

### II. Si-Paste (nicht erfindungsgemäß)

| | | |
|---|---|---|
| 48g | 1.2-Propandiol | |
| 3g | TEOS | |
| 3g | Milchsäure | |
| 5g | Ethylenglykolmonobutylether | |
| 3g | Trasil® | |
| 5g | Byk 410® | Thixotropiermittel |
| 0,4g | TEGO Glide 400® | Verlaufsmiftel |
| 4g | PVP | Verdicker. |

## Patentansprüche

1. Druckfähige Dotierpasten für die Herstellung von p, p+, p++, n, n+, n++-Bereichen in Si-Wafern, enthaltend
a) eine oder mehrere dotierend wirkende Komponenten,
b) ein oder mehrere Alkoxysilane, die gegebenenfalls vorhydrolysiert werden müssen, und
c) Lösungsmittel,
wobei die Gesamtzusammensetzung Verunreinigungen in Form von Metallionen in jeweiligen Konzentrationen von weniger als 500 ppb, vorzugsweise von weniger als 200 ppb aufweist.

2. Dotierpaste gemäß Anspruch 1, wobei die Alkoxysilan(e) ausgewählt sind aus der allgemeinen Formel 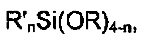 worin
| | |
|---|---|
| R" | Methyl, Ethyl oder Phenyl, |
| R | Methyl, Ethyl, n-Propyl, oder i-Propyl, und |
| n | 0, 1 oder 2 |
bedeuten.

3. Dotierpaste gemäß Anspruch 1, wobei die Alkoxysilane, ausgewählt sind aus der Gruppe Tetramethoxysilan, Tetraethoxysilan, Tetrabutoxysilan, Tetrapropoxysilan, Tetramethoxysilan einzeln oder im Gemisch.

4. Dotierpaste gemäß Anspruch 1, wobei die Alkoxysilane in einer Menge in einem Bereich von 0,1-5 Gew.% enthalten sind.

5. Dotierpaste gemäß Anspruch 1, enthaltend eine Säure und Wasser und gegebenenfalls Additive, wie Verdickungsmittel oder Netzmittel.

6. Dotierpaste gemäß Anspruch 1, enthaltend eine Dotierquelle ausgewählt aus der Gruppe Borsalz, Boroxid, Borsäure, organischen Verbindungen des Bors, Bor-Aluminiumverbindungen und Phosphorsalz Phosphoroxid, Phosphorpentoxid, Phosphorsäure, phosphororganische Verbindungen, organische Verbindungen des Aluminiums und Aluminiumsalze.

7. Dotierpaste gemäß Anspruch 1, enthaltend ein oder mehrere Dotierquellen ausgewählt aus der Gruppe Boroxid (B₂O₃), Borsäure B(OH)₃, Phosphorsäure (H₃P0₄), Phosphorpentoxid (P₂O₅) und Aluminiumsalz, wobei die Dotierungsquellen in unterschiedlichen Konzentrationen eingesetzt werden können.

8. Dotierpaste gemäß Anspruch 1, enthaltend eine oder mehrere Dotierquellen aus der Gruppe der organischen Verbindungen des Bors, Phosphors und Aluminiums, wobei die Dotierungsqueilen in unterschiedlichen Konzentrationen eingesetzt werden können.

9. Dotierpaste gemäß Anspruch 1, enthaltend ein oder mehrere Dotierquellen ausgewählt aus der Gruppe Boroxid (B₂O₃), Borsäure B(OH)₃, Phosphorsäure (H₃PO₄), Phosphorpentoxid (P₂O₅) und Aluminiumsalz und gegebenenfalls eine oder mehrere Dotierquellen aus der Gruppe der organischen Verbindungen des Bors, Phosphors und Aluminiums, wobei die Dotierungsquellen in unterschiedlichen Konzentrationen eingesetzt werden können.

10. Dotierpaste gemäß Anspruch 1, welche die Dotierkomponenten B₂O₃ bzw. P₂O₅ in einer Menge bezogen auf die SiO₂-bildende Komponente enthalten, die zu einem Verhältnis von B₂O₃ bzw. P₂O₅ von 10-80% in SiO₂ führt.

11. Dotierpaste gemäß einem der Ansprüche 1 bis 10, enthaltend ein oder mehrere Lösungsmittel ausgewählt aus der Gruppe der hydrophilen Polyalkohole, deren Ether oder Ester, der hydrophilen Ether, Aldehyde, Ketone oder Ester oder Gemische.

12. Dotierpaste gemäß einem der Ansprüche 1 bis 11, enthaltend 30 - 95 Gew% 1,2 Propandiol im Gemisch mit einem oder mehreren Lösungsmitteln ausgewählt aus der Gruppe Ethylenglycolmonobutylether (EGB), Diethylenglycolmonobutylether (DGB), Dipropylenglycolmonomethylether (DPM), 1.4 Butandiol (1.4BD), und 1.3 Butandiol (1.3BD) und/oder ein oder mehrere Lösungsmittel ausgewählt aus der Gruppe Dioxan, Trioxan, Tetrahydrofuran, und Tetrahydropyran Methylal, Diethylacetal, Methylethylketon, Methylisobutylketon, Diethylketon, Acetonylaceton, Diacetonalkohol Ameisensäuremethyl-, Ameisensäureethyl-, Ameisensäurepropyl-, Essigsäuremethyl-, und Essigsäureethyl-ester.

13. Dotierpaste gemäß einem der Ansprüche 1 bis 12, enthaltend Tetraethylorthosilikat, 1,2-Propandiol , N-Methylpyrrolidon, Ethylenglykolmonobutylether, 1,4-Butandiol oder Gemische davon als Lösungsmittel, Milchsäure als Säure, P₂O₅ oder B₂O₃ als Dotiermittel und als Additive Verlaufsmittel, Thixotropiermittel, Verdicker und gegebenenfalls Entschäumer und Entlüfter.

14. Verwendung einer Dotierpaste gemäß einem oder mehreren der Ansprüche 1 bis 13 zum ganzflächigen Bedrucken von Si-Wafem.

15. Verwendung einer Dotierpaste gemäß einem oder mehreren der Ansprüche 1 bis 13 zum selektiven Bedrucken von Si-Wafern zur Herstellung von p, P+, P++, n, n+ , n++-Bereichen im Si-Wafer.

16. Verwendung einer Dotierpaste gemäß einem oder mehreren der Ansprüche 1 bis 13 zum selektiven Bedrucken und Strukturieren von Si-Wafern zur Herstellung von p, P+, P++, n, n+ , n++-Bereichen im Si-Wafer.

17. Verwendung einer Dotierpaste gemäß einem oder mehreren der Ansprüche 1 bis 13 für den Sieb-, Rollen-, Tampon- oder Schablonendruck in der Halbleitertechnologie.

18. Verwendung einer Dotierpaste gemäß einem oder mehreren der Ansprüche 1 bis 13 in der Halbleitertechnik, der hotovoltiak oder in der Leistungselektronik.

19. Verfahren zur Dotierung von Si-Wafern enthaltend:
- Bereitstellen einer Dotierpaste gemäß einem der Ansprüche 1 bis 13,
- Belegen des Si-Wafer mit der Dotierpaste,
- Umwandlung der aufgebrachten Dotierpaste in die erwünschten dotierenden Schichten durch Erhitzen auf Temperaturen von 200 bis 600°C,
- Durchführen des Dotierprozesses durch kontrollierte Diffusion in Luft oder Sauerstoff Atmosphäre.

## Claims

1. A printable dopant paste for the production of p, p+, p++, n, n+, n++ regions in silicon wafers, comprising
a) one or more dopant components,
b) one or more alkoxysilanes which may need to be prehydrolyzed and
c) solvents,
wherein the overall composition has impurities in the form of metal ions in respective concentrations of less than 500 ppb, preferably of less than 200 ppb.

2. The dopant paste according to claim 1, wherein the alkoxysilane(s) is/are selected from the general formula 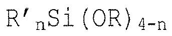 in which
| | |
|---|---|
| R" | is methyl, ethyl or phenyl, |
| R | is methyl, ethyl, n-propyl or i-propyl, and |
| n | is 0, 1 or 2. |

3. The dopant paste according to claim 1, wherein the alkoxysilanes are selected from the group of tetramethoxysilane, tetraethoxysilane, tetrabutoxysilane, tetrapropoxysilane, individually or in a mixture.

4. The dopant paste according to claim 1, wherein the alkoxysilanes are present in an amount within a range of 0.1-5% by weight.

5. The dopant paste according to claim 1, comprising an acid and water and optionally additives such as thickeners or wetting agents.

6. The dopant paste according to claim 1, comprising a dopant source selected from the group of boron salt, boron oxide, boric acid, organic compounds of boron, boron-aluminum compounds and phosphorus salt, phosphorus oxide, phosphorus pentoxide, phosphoric acid, organophosphorus compounds, organic compounds of aluminum and aluminum salts.

7. The dopant paste according to claim 1, comprising one or more dopant sources selected from the group of boron oxide (B₂O₃), boric acid B(OH)₃, phosphoric acid (H₃PO₄), phosphorus pentoxide (P₂O₅) and aluminum salt, the dopant sources being usable in different concentrations.

8. The dopant paste according to claim 1, comprising one or more dopant sources from the group of the organic compounds of boron, of phosphorus and of aluminum, the dopant sources being usable in different concentrations.

9. The dopant paste according to claim 1, comprising one or more dopant sources selected from the group of boron oxide (B₂O₃), boric acid B(OH)₃, phosphoric acid (H₃PO₄), phosphorus pentoxide (P₂O₅) and aluminum salt and optionally one or more dopant sources from the group of the organic compounds of boron, of phosphorus and of aluminum, the dopant sources being usable in different concentrations.

10. The dopant paste according to claim 1, which comprises the dopant components B₂O₃ and P₂O₅ in an amount based on the SiO₂-forming component which leads to respective ratios of B₂O₃ and P₂O₅ of 10-80% in SiO₂.

11. The dopant paste according to any of claims 1 to 10, comprising one or more solvents selected from the group of the hydrophilic polyalcohols, ethers or esters thereof, the hydrophilic ethers, aldehydes, ketones or esters or mixtures.

12. The dopant paste according to any of claims 1 to 11, comprising 30-95% by weight of 1,2-propanediol in a mixture with one or more solvents selected from the group of ethylene glycol monobutyl ether (EGB), diethylene glycol monobutyl ether (DGB), dipropylene glycol monomethyl ether (DPM), 1,4-butanediol (1,4-BD) and 1,3-butanediol (1,3-BD), and/or one or more solvents selected from the group of dioxane, trioxane, tetrahydrofuran and tetrahydropyran, methylal, diethyl acetal, methyl ethyl ketone, methyl isobutyl ketone, diethyl ketone, acetonylacetone, diacetone alcohol, methyl formate, ethyl formate, propyl formate, methyl acetate and ethyl acetate.

13. The dopant paste according to any of claims 1 to 12, comprising tetraethyl orthosilicate, 1,2-propanediol, N-methylpyrrolidone, ethylene glycol monobutyl ether, 1,4-butanediol or mixtures thereof as solvents, lactic acid as an acid, P₂O₅ or B₂O₃ as a dopant and, as additives, leveling agents, thixotropic agents, thickeners and optionally defoamers and devolatilizers.

14. The use of a dopant paste according to one or more of claims 1 to 13 for whole-area printing of silicon wafers.

15. The use of a dopant paste according to one or more of claims 1 to 13 for selective printing of silicon wafers for production of p, p+, p++, n, n+, n++ regions in the silicon wafer.

16. The use of a dopant paste according to one or more of claims 1 to 13 for selective printing and structuring of silicon wafers for production of p, p+, p++, n, n+, n++ regions in the silicon wafer.

17. The use of a dopant paste according to one or more of claims 1 to 13 for screen printing, roller printing, pad printing or stencil printing in semiconductor technology.

18. The use of a dopant paste according to one or more of claims 1 to 13 in semiconductor technology, photovoltaics or in power electronics.

19. Process for doping silicon wafers, comprising:
- providing a dopant paste according to any of claims 1 to 13,
- covering the silicon wafer with the dopant paste,
- converting the dopant paste applied to the desired doped layers by heating to temperatures of 200 to 600°C,
- performing the doping process by controlled diffusion in an air or oxygen atmosphere.

## Revendications

1. Pâtes de dopage imprimables pour la préparation de zones p, p+, p++, n, n+, n++ dans des plaquettes de Si, contenant
a) un ou plusieurs composants à effet dopant,
b) un ou plusieurs alcoxysilanes, qui doivent le cas échéant être préhydrolysés et
c) un solvant,
la composition totale présentant des impuretés sous forme d'ions métalliques en des concentrations à chaque fois de moins de 500 ppb, de préférence de moins de 200 ppb.

2. Pâte de dopage selon la revendication 1, le(s) alcoxysilane(s) étant choisi(s) parmi la formule générale 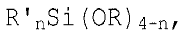 où
| | |
|---|---|
| R' | signifie méthyle, éthyle ou phényle, |
| R | signifie méthyle, éthyle, n-propyle, ou i-propyle, et |
| n | vaut 0, 1 ou 2. |

3. Pâte de dopage selon la revendication 1, les alcoxysilanes étant choisis dans le groupe formé par le tétraméthoxysilane, le tétraéthoxysilane, le tétrabutoxysilane, le tétrapropoxysilane, seuls ou en mélange.

4. Pâte de dopage selon la revendication 1, les alcoxysilanes étant contenus en une quantité dans la plage de 0,1-5% en poids.

5. Pâte de dopage selon la revendication 1, contenant un acide et de l'eau et le cas échéant des additifs, tels que des épaississants ou des mouillants.

6. Pâte de dopage selon la revendication 1, contenant une source de dopage, choisie dans le groupe formé par un sel borique, un oxyde de bore, l'acide borique, des composés organiques du bore, des composés de bore-aluminium et un sel de phosphore, un oxyde de phosphore, le pentoxyde de phosphore, l'acide phosphorique, des composés organiques du phosphore, des composés organiques de l'aluminium et des sels d'aluminium.

7. Pâte de dopage selon la revendication 1, contenant une ou plusieurs sources de dopage, choisies dans le groupe formé par l'oxyde de bore (B₂O₃) , l'acide borique B(OH)₃, l'acide phosphorique (H₃PO₄), le pentoxyde de phosphore (P₂O₅) et un sel d'aluminium, les sources de dopage pouvant être utilisées en différentes concentrations.

8. Pâte de dopage selon la revendication 1, contenant une ou plusieurs sources de dopage du groupe des composés organiques du bore, du phosphore et de l'aluminium, les sources de dopage pouvant être utilisées en différentes concentrations.

9. Pâte de dopage selon la revendication 1, contenant une ou plusieurs sources de dopage, choisies dans le groupe formé par l'oxyde de bore (B₂O₃), l'acide borique B(OH)₃, l'acide phosphorique (H₃PO₄), le pentoxyde de phosphore (P₂O₅) et un sel d'aluminium et le cas échéant une ou plusieurs sources de dopage du groupe des composés organiques du bore, du phosphore et de l'aluminium, les sources de dopage pouvant être utilisées en différentes concentrations.

10. Pâte de dopage selon la revendication 1, qui contiennent les composants de dopage B₂O₃ ou, selon le cas, P₂O₅ en une quantité, par rapport au composant formant le SiO₂, qui conduit à un rapport de B₂O₃ ou, selon le cas, P₂O₅ de 10-80% dans le SiO₂.

11. Pâte de dopage selon l'une quelconque des revendications 1 à 10, contenant un ou plusieurs solvants, choisis dans le groupe des polyalcools hydrophiles, leurs éthers ou esters, des éthers, aldéhydes, cétones ou esters hydrophiles ou leurs mélanges.

12. Pâte de dopage selon l'une quelconque des revendications 1 à 11, contenant 30-95% en poids de 1,2-propanediol en mélange avec un ou plusieurs solvants choisis dans le groupe formé par l'éthylèneglycolmonobutyléther (EGB), le diéthylèneglycolmonobutyléther (DGB), le dipropylèneglycolmonométhyléther (DPM), le 1,4-butanediol (1,4 BD) et le 1,3-butanediol (1,3 BD) et/ou un ou plusieurs solvants choisis dans le groupe formé par le dioxane, le trioxane, le tétrahydrofuranne et le tétrahydropyranne, le méthylal, le diéthylacétal, la méthyléthylcétone, la méthylisobutylcétone, la diéthylcétone, l'acétonylacétone, l'alcool de diacétone, l'ester méthylique, éthylique, propylique de l'acide formique, l'ester méthylique et l'ester éthylique de l'acide acétique.

13. Pâte de dopage selon l'une quelconque des revendications 1 à 12, contenant du tétraéthylorthosilicate, du 1,2-propanediol, de la N-méthylpyrrolidone, de l'éthylèneglycolmonobutyléther, du 1,4-butanediol ou leurs mélanges comme solvant, de l'acide lactique comme acide, du P₂O₅ ou du B₂O₃ comme agent de dopage et, comme additifs, des agents d'étalement, de thixotropie, des épaississants et le cas échéant des antimousses et des agents de désaération.

14. Utilisation d'une pâte de dopage selon l'une ou plusieurs des revendications 1 à 13 pour l'impression de toute la surface de plaquettes de Si.

15. Utilisation d'une pâte de dopage selon l'une ou plusieurs des revendications 1 à 13 pour l'impression sélective de plaquettes de Si pour la réalisation de zones p, p+, p++, n, n+, n++ dans des plaquettes de Si.

16. Utilisation d'une pâte de dopage selon l'une ou plusieurs des revendications 1 à 13 pour l'impression sélective et la structuration de plaquettes de Si pour la réalisation de zone p, p+, p++, n, n+, n++ dans des plaquettes de Si.

17. Utilisation d'une pâte de dopage selon l'une ou plusieurs des revendications 1 à 13 pour l'impression par sérigraphie, sur rotative, au tampon ou au pochoir dans la technologie des semi-conducteurs.

18. Utilisation d'une pâte de dopage selon l'une ou plusieurs des revendications 1 à 13 dans la technique des semi-conducteurs, la photovoltaïque ou dans l'électronique de puissance.

19. Procédé pour le dopage de plaquettes de Si, contenant :
- la préparation d'une pâte de dopage selon l'une quelconque des revendications 1 à 13,
- le revêtement de la plaquette de Si avec la pâte de dopage,
- la transformation de la pâte de dopage appliquée en couches dopantes souhaitées par chauffage à des températures de 200 à 600°C,
- la réalisation du processus de dopage par diffusion contrôlée dans l'air ou une atmosphère d'oxygène.
